## Europäisches Patentamt
## European Patent Office
## Office européen des brevets

(19)

(11) Veröffentlichungsnummer: **0 346 468**
**A1**

(12)
# EUROPÄISCHE PATENTANMELDUNG
Veröffentlicht nach Art. 158 Abs. 3 EPÜ

(21) Anmeldenummer: **88901159.9**

(22) Anmeldetag: **16.11.87**

Daten der zugrundeliegenden internationalen Anmeldung:

(86) Internationale Anmeldenummer:
**PCT/SU87/00128**

(87) Internationale Veröffentlichungsnummer:
**WO89/04879 (01.06.89 89/12)**

(51) Int. Cl.³: **C 23 C 4/00**
**C 23 C 14/34**

(43) Veröffentlichungstag der Anmeldung:
**20.12.89 Patentblatt 89/51**

(84) Benannte Vertragsstaaten:
**CH DE FR GB IT LI SE**

(71) Anmelder: **NAUCHNO-PROIZVODSTVENNOE OBIEDINENIE PO VYPUSKU MEKHANICHESKOGO SVAROCHNOGO OBORUDOVANIA (NPO 'VISP')**
**ul. Polevaya 24**
**Kiev, 252056(SU)**

(72) Erfinder: **BOGUSLAVSKY, Alexandr Moiseevich**
**pr. Pobedy, 21-74**
**Kiev, 252055(SU)**

(72) Erfinder: **SEMENIKHIN, Viktor Filatovich**
**ul. Volgogradskaya, 25a-61**
**Kiev, 252141(SU)**

(72) Erfinder: **CHERGIKALO, Vladimir Ivanovich**
**ul. Vyborgskaya, 25-63**
**Kiev, 252056(SU)**

(72) Erfinder: **ROZENMAN, Lev Isidorovich**
**ul. Parkhomenko, 60-136**
**Kiev, 252112(SU)**

(72) Erfinder: **TREGUB, Yakov Konstantinovich**
**Darnitsky bulvar, 11-76**
**Kiev, 252192(SU)**

(72) Erfinder: **RISMAN, Arkady Isaakovich**
**Kolomievsky per., 11-45**
**Kiev, 252127(SU)**

(72) Erfinder: **TOPOPOLSKY, Yankel Meerovich**
**ul. Dorogozhitskaya, 15b-61**
**Kiev, 252112(SU)**

(72) Erfinder: **KHATANZEISKY, Egor Vasilievich**
**ul. Garmatnaya, 39b-24**
**Kiev, 252067(SU)**

(72) Erfinder: **RUBIN, Eduard Abramovich**
**ul. Kruglo-Universitetskaya, 7-24**
**Kiev, 252024(SU)**

(74) Vertreter: **Nix, Frank Arnold, Dr.**
**Kröckelbergstrasse 15**
**D-6200 Wiesbaden(DE)**

(54) **VORRICHTUNG ZUM GASOTHERMISCHEN BESCHICHTEN VON TEILEN.**

(57) Die Anlage enthält eine Kammer (1), in welcher ein Spindelstock und ein Reitstock (3, 5) angeordnet sind. Der Spindelstock 3 ist mit einem Antrieb (4) zur Drehbewegung versehen, während der Reitstock (5) so angeordnet ist, daß er in einer Führung (7) Längsbewegungen ausführen kann. Die Anlage enthält auch eine Stange (16) mit einem Zerstäuber (17), die mittels eines Antriebes (19) in an einem Schlitten (13) befestigten Führungen (18) Querbewegungen ausführen kann, wobei der Schlitten (13) so angeordnet ist, daß er mittels eines Antriebes (14) in den Führungen (15) Längs-bewegungen ausführen kann. An der Führung (7), in welcher eine Öffnung (23) vorgesehen ist, ist ein Tisch (20) an-gebracht, dessen Abmessungen kleiner als die Abmessun-gen der Öffnung (23) sind. Die hintere Wand (11) der Kammer (1) hat einen Längsschlitz (40), während die Kammer (1) mit einem Schieber (41) versehen ist, welcher längsbewegbar an-geordnet ist und mit einem Hohlstößel (43) in Wechselwirkung steht, der am Schlitten (13) befestigt ist und in dem die

./...

Stange (16) untergebracht ist. Die Antriebe (14 und 19) sind an der Außenseite der hinteren Wand (11) der Kammer (1) angeordnet.

FIG. 1

# ANLAGE ZUM AUFTRAGEN VON GASTHERMISCHEN ÜBERZÜGEN AUF WERKSTÜCKE

## Gebiet der Technik

Die vorliegende Erfindung bezieht sich auf die Technik zum Auftragen von gasthermischen Überzügen auf Werkstücke durch Zerstäubung und betrifft insbesondere eine Anlage zum Auftragen von gasthermischen Überzügen auf Werkstücke.

## Zugrundeliegender Stand der Technik

Es ist eine Anlage zum Auftragen von gasthermischen Überzügen auf Werkstücke vom Typ Rotationskörper bekannt /Rotomat, Schweiz, Modular equipment for automatic coating/. Die Anlage enthält einen Spindelstock, der mit einem Antrieb zur Drehbewegung des Werkstückes versehen ist, sowie einen Reitstock mit einer gemeinsamen Spitzenachse. Der Reitstock ist an einer Führung längsbewegbar angeordnet. An derselben Führung ist ein Schlitten angeordnet, der hin- und hergehende Längsbewegungen ausführen kann.

Die Anlage enthält auch eine Stange mit einem an dieser angebrachten Zerstäuber, welche Stange in am Schlitten befestigten Führungen querbewegbar angeordnet ist. Die Stange ist mit einem Spanner versehen, mit dem die Querstellung der Stange relativ zu der Spitzenachse fixiert wird. Das Werkstück vom Typ Rotationskörper wird in dem Spindelstock und dem Reitstock aufgenommen. Beim Aufnehmen des Werkstückes wird der Reitstock in Längsrichtung bewegt und an die Stirnfläche des Werkstückes herangeführt. Nach dem Aufnehmen des Werkstückes wird die Stange mit dem Zerstäuber in Querrichtung bewegt und in eine Stellung gebracht, die sich nach dem Durchmesser des Werkstückes und dem von der Technologie vorgegebenen Abstand zwischen dem Zerstäuber und der Oberfläche des Werkstückes richtet. Die Stellung der Stange wird mittels des Spanners fixiert. Es wird der Antrieb zur Drehbewegung des Werkstückes eingeschaltet, und der Schlitten führt hin- und hergehende Längsbewegungen aus, deren Anzahl von der Technologie vorgegeben wird. Da die Stange mit dem Zerstäuber in ihrer Querstellung fixiert ist, werden die Überzüge lediglich auf zylindrische Werkstücke aufgetragen. Beim Auftragen des Überzuges gelangt ein Teil des zu zerstäubenden pulverförmigen Materials auf die Führungen des Reitstockes, wodurch dessen Bewegung in der Führung erschwert wird und ein vorzeitiger Verschleiß der Führung verursacht wird.

Es ist eine Anlage zum Auftragen von gasthermischen Überzügen auf Werkstücke (PLASMA-TECHNIK AG, Schweiz, Wellenspritzbank Typ WSP mit Schallschutzhaube) bekannt, die eine Kammer, in der Kammer koaxial angeordnete: einen Spindelstock, welcher mit einem Antrieb zur Drehbewegung versehen ist, und einen Reitstock mit einer Führung enthält, der längsbewegbar in dieser Führung angeordnet ist. Die Anlage enthält auch einen Schlitten mit einem Antrieb und einer Führung, wobei der Schlitten so angeordnet ist, daß er hin- und hergehende Längsbewegungen über die Führung ausführen kann, sowie eine Stange mit einem an dieser angebrachten Zerstäuber, die querbewegbar in den am Schlitten befestigten Führungen angeordnet ist. Die Führung des Reitstockes, die Führung des Schlittens und der Antrieb zur Längsbewegung des Schlittens sind in der Kammer untergebracht, wobei sich die Führung des Reitstockes unterhalb des Zerstäubers befindet. Bei den offenen Türen der Kammer wird das Werkstück vom Typ Rotationskörper im Spindelstock und im Reitstock aufgenommen. Die Stange mit dem Zerstäuber wird in Querrichtung bewegt und in eine Stellung gebracht, die sich nach dem Durchmesser des Werkstückes und dem von der Technologie vorgegebenen Abstand zwischen dem Zerstäuber und der Oberfläche des Werkstückes richtet.Die Türen der Kammer werden geschlossen, und es wird der Antrieb zur Drehbewegung des Werkstückes eingeschaltet. In den Zerstäuber werden die Überzugskom-

ponenten zugeführt, und der Schlitten führt hin- und hergehende Längsbewegungen aus, deren Anzahl von der Technologie vorgegeben wird. Beim Auftragen eines Überzuges auf ein zylindrisches Werkstück eines konstanten Durchmessers bleibt die Stange mit dem Zerstäuber während der gesamten Zeit der Zerstäubung in ihrer Querstellung unveränderlich. Beim Auftragen eines Überzuges auf ein Werkstück mit einem veränderlichen Durchmesser wird die Stange mit dem Zerstäuber in der Querrichtung um eine vorgegebene Größe vereinigt, die der Halbmesserdifferenz gleich ist.

Die Anlage ist zum Auftragen von Überzügen auf zylindrische Werkstücke eines kleinen Durchmessers, die folglich eine kleine Überzugsfläche aufweisen, bestimmt, deshalb sind die Zeit des kontinuierlichen Betriebes des Zerstäubers und die Betriebszeit der Antriebe der Anlage von einer kurzen Dauer. Die Arbeit der Antriebe sowie der Führungen in der Zone hoher Temperatur und eines hohen beim Betrieb des Zerstäubers anfallenden Staubgehaltes innerhalb einer kurzen Zeit beeinflußt die Betriebsfähigkeit der Antriebe praktisch nicht.

Die Konstruktion der bekannten Anlage ermöglicht es nicht, daß Überzüge auf flache Werkstücke aufgetragen werden, weil beim Auftragen von Überzügen auf solche Werkstücke zusätzliche Verschiebungen des Zerstäubers und die Befestigung des flachen Werkstückes in der Kammer erforderlich sind. Das Auftragen von Überzügen auf flache Werkstücke, die im wesentlichen große Oberflächen haben, erfordert ferner eine Verlängerung der Zeit des kontinuierlichen Betriebes des Zerstäubers, was sich auf die Betriebsfähigkeit und die Lebensdauer der Antriebe und der Führungen, die sich eine längere Zeit in der Zone hoher Temperatur und eines hohen Staubgehaltes befinden, negativ auswirkt. Die Anordnung der Führung des Reitstockes unterhalb des Zerstäubers trägt dazu bei, daß das pulverförmige Material des Überzuges auf die Führung gelangt,

- 4 -

wodurch die Bewegung des Reitstockes in dieser Führung verhindert und die Verleißfestigkeit derselben vermindert werden.

Offenbarung der Erfindung

Der vorliegenden Erfindung liegt die Aufgabe zugrunde, eine Anlage zum Auftragen von gasthermischen Überzügen auf Werkstücke zu schaffen, deren gerätetechnische Ausführung es ermöglicht, hin- und hergehende Bewegungen des Zerstäubers in Längs- und Querrichtung gleichzeitig auszuführen, flache Werkstücke in der Kammer zu befestigen sowie Bedingungen für einen längeren Betrieb der Anlage sicherzustellen, wodurch die technologischen Möglichkeiten der Anlage erweitert und deren Zuverlässigkeit erhöht werden können.

Die gestellte Aufgabe wird dadurch gelöst, daß eine Anlage zum Auftragen von gasthermischen Überzügen auf Werkstücke, enthaltend eine kastenförmige Kammer, in der Kammer koaxial angeordnet : einen Spindelstock, welcher mit einem Antrieb zur Drehbewegung versehen ist, und einen Reitstock mit einer Führung, der Längsbewegungen relativ zum Werkstück in dieser Führung ausführen kann, einen Schlitten mit einem Antrieb und einer Führung, der hin- und hergehende Längsbewegungen relativ zum Werkstück in der Führung ausführen kann, eine Stange mit einem an dieser angebrachten Zerstäuber, die in am Schlitten befestigten Führungen Querbewegungen relativ zum Werkstück ausführen kann, erfindungsgemäß einen Tisch, der an der Führung des Reitstockes befestigt ist, in dem eine Öffnung mit die Querschnittsabmessungen des Tisches übersteigenden Abmessungen vorgesehen ist, einen Antrieb zur hin- und hergehenden Querbewegung der Stange relativ zum Werkstück sowie eine mit dem genannten Antrieb kinematisch verbundene Einrichtung zur Änderung der Kolbenhubgröße enthält, wobei die hintere Wand der Kammer einen Längsschlitz hat, und die Kammer mit einer Klappe versehen ist, welche so angeordnet ist,

- 5 -

daß sie Längsbewegungen relativ zum Werkstück ausführen kann und mit einem Hohlstößel in Wechselwirkung steht, der am Schlitten befestigt ist und in dem die Stange untergebracht ist, und außerdem der Antrieb des Schlittens und der Antrieb zur hin- und hergehenden Querbewegung der Stange sowie die Führungen des Schlittens und der Stange an der Außenseite der hinteren Wand der Kammer angeordnet sind.

Es ist zweckmäßig, daß der Antrieb zur hin- und hergehenden Querbewegung der Stange in Form einer Kurve und eines zweiarmigen Hebels ausgebildet ist, bei dem der eine Arm mit der Kurve und der andere Arm mit der Stange verbunden sind.

Es ist vorzuziehen, daß die Einrichtung zur Änderung der Stangenhubgröße zwei Gleitstücke, welche in Nuten verschiebbar angeordnet sind, von denen die eine Nut im Schlitten und die andere Nut im zweiarmigen Hebel des Antriebes zur hin- und hergehenden Querbewegung der Stange ausgeführt sind, sowie einen in den Gleitstücken angeordneten Gelenkbolzen enthält.

Es ist notwendig, daß die Länge und die Breite des Tisches Abmessungen aufweisen, die die Abmessungen der Flächen der Führung des Reitstockes übersteigen, welche mit dem Reitstock in Wechselwirkung stehen.

Zum Auftragen der Überzüge auf Werkstücke vom Typ Rotationskörper, welche eine vom Zylinder abweichende Form aufweisen, ist es notwendig, daß das Profil der Kurve des Antriebes zur hin- und hergehenden Querbewegung der Stange dem Profil der Oberfläche des Werkstückes entspricht, auf welche der Überzug aufgetragen wird.

Die erfindungsgemäße Anlage gestattet es, Überzüge auf Werkstücke vom flachen Typ, vom Typ Rotationskörper, die eine zylindrische Form oder eine vom Zylinder abweichende Form aufweisen, aufzutragen.

Kurze Beschreibung der Zeichnungen

Nachstehend wird die vorliegende Erfindung anhand eines konkreten Ausführungsbeispiels der Erfindung und der beigefügten Zeichnungen erläutert. Es zeigen:

Fig. 1 - die Gesamtansicht einer erfindungsgemäßen Anlage zum Auftragen von gasthermischen Überzügen auf Werkstücke in Frontansicht;

Fig. 2 - die Gesamtansicht einer erfindungsgemäßen Anlage mit der abgehobenen Kammer in Draufsicht;

Fig. 3 - einen Schnitt nach Linie III-III in Fig. 1, gemäß der Erfindung;

Fig. 4 - den Schnitt nach der Linie IV-IV in Fig. 2, gemäß der Erfindung;

Fig. 5 - die Konstruktion des Antriebes zur hin-hergehenden Querbewegung der Stange, gemäß der Erfindung;

Fig. 6 - den Schnitt nach der Linie VI-VI in Fig. 5, gemäß der Erfindung;

Fig. 7 - die schematische Darstellung einer erfindungsgemäßen Anlage beim Auftragen eines Überzugs auf ein Werkstück vom Typ Rotationskörper, das eine vom Zylinder abweichende Form aufweist;

Fig. 8 - einen teilweisen Querschnitt durch die hintere Wand der Kammer, gemäß der Erfindung;

Fig. 9 - die teilweise Hinteransicht der hinteren Wand der Kammer, gemäß der Erfindung;

Fig. 10 - in schematischer Darstellung die Anordnung des Zerstäubers an der Stange, gemäß der Erfindung.

Bevorzugte Ausführungsvariante der Erfindung

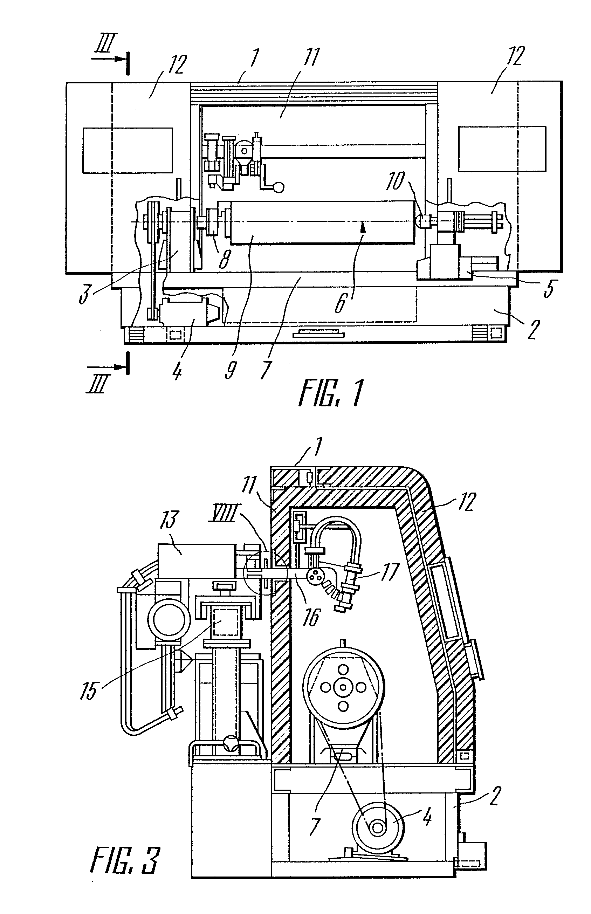

Die Anlage zum Auftragen von gasthermischen Überzügen auf Werkstücke enthält eine kastenförmige Kammer 1 (Fig. 1), die auf einer Grundplatte 2 befestigt ist, in der Kammer 1 angeordnet : einen Spindelstock 3, der mit einem Antrieb 4 zur Drehbewegung versehen ist, und einen Reitstock 5 mit einer gemeinsamen Achse 6 der Spitzen. Der Reitstock 5 ist an einer Führung 7 so angeordnet, daß er Längsbewegungen ausführen und in der Längsstellung fixiert werden kann (der Feststeller ist in den Zeichnungen nicht wiedergegeben). Am Spindelstock 3 ist ein Futter 8 zum Festspannen eines Werkstückes 9 vom Typ Rotationskörper

- 7 -

mit der          Achse 6     und am Reitstock 5 - eine rotierende Spitze 10 angeordnet. Die Kammer 1 enthält
eine hintere Wand 11 und im vorderen Teil derselben angeordnete Schiebetüren 12.

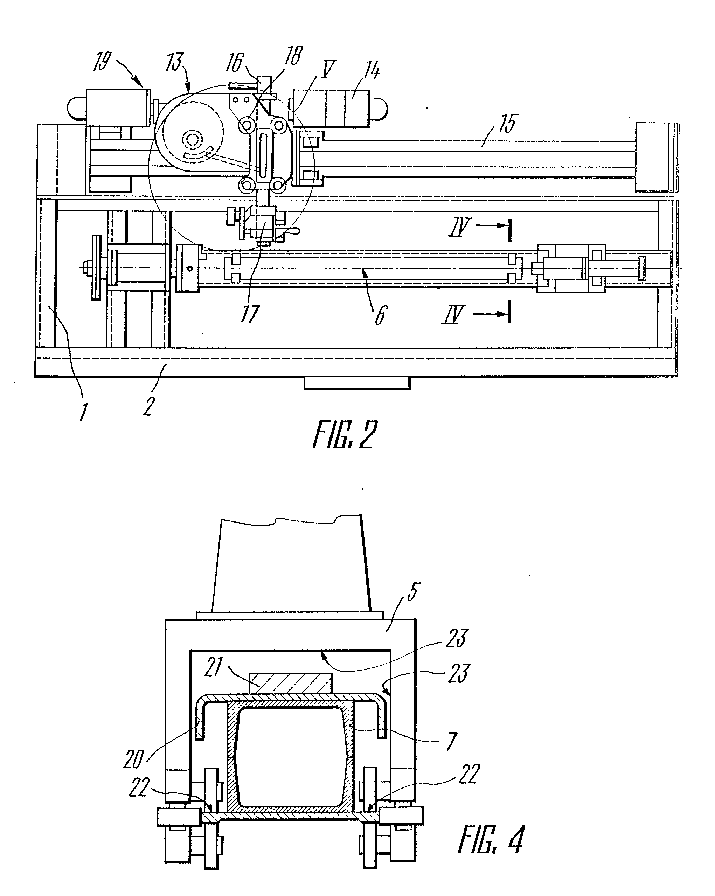

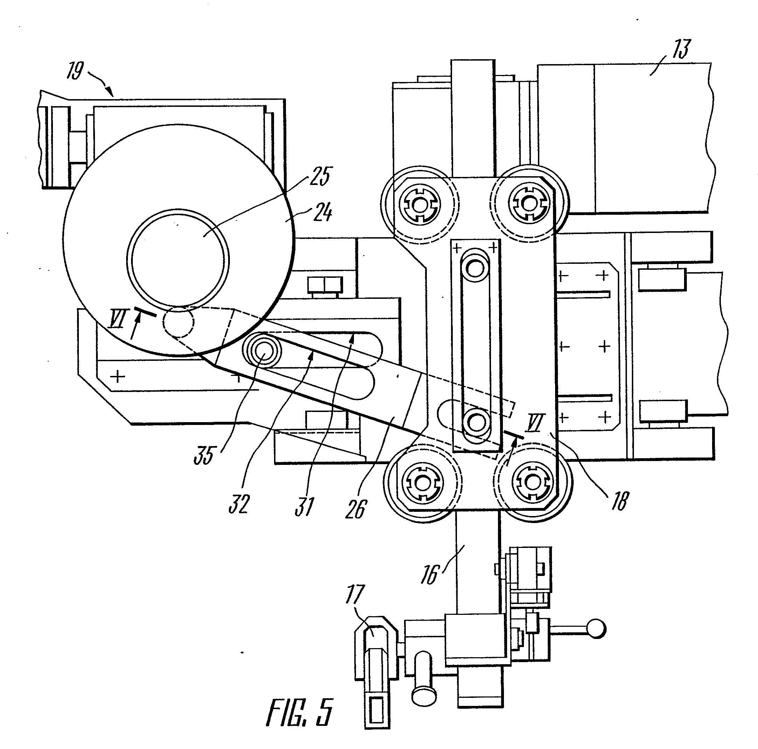

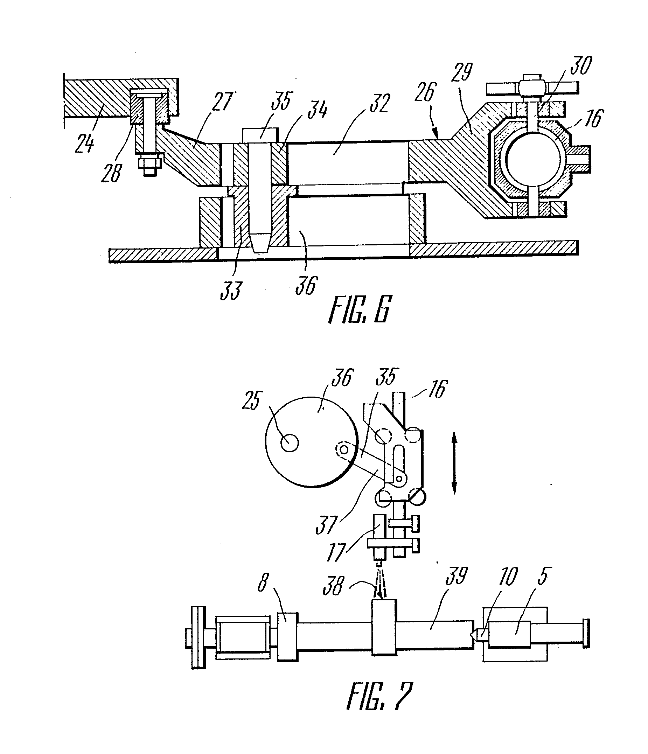

Die Anlage enthält auch einen Schlitten 13 (Fig. 2)
mit einem Antrieb 14 zur hin- und hergehenden Längsbewegung des Werkstückes 9 in einer Führung 15. Am Schlitten
13 ist eine Stange 16 mit einem an diesem angeordneten
Zerstäuber 17 angebracht. Die Stange 16 ist in am Schlitten 13 befestigten Führungen 18 so angeordnet, daß sie
hin- und hergehende Querbewegungen relativ zum Werkstück
9 mittels eines Antriebes 19 ausführen kann. Die Antriebe 14 und 19 sowie die Führungen 15 und 18 sind an der
Außenseite der hinteren Wand 11 der Kammer 1 (Fig. 3)
angeordnet. An der Führung 7 ist ein Tisch 20 (Fig. 4)
zur Aufnahme eines flachen Werkstückes 21 befestigt. Die
Länge und die Breite des Tisches 20 überschreiten die
entsprechenden Abmessungen der Flächen 22 der Führung
7, welche mit dem Reitstock 5 in Wechselwirkung stehen.
Der Reitstock 5 hat eine Öffnung 23, deren Abmessungen
die Abmessungen des Querschnittes des Tisches 20 überschreiten.

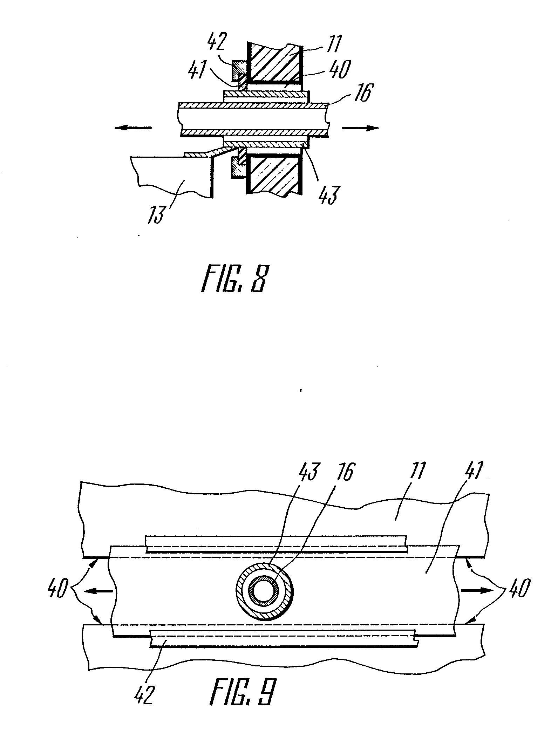

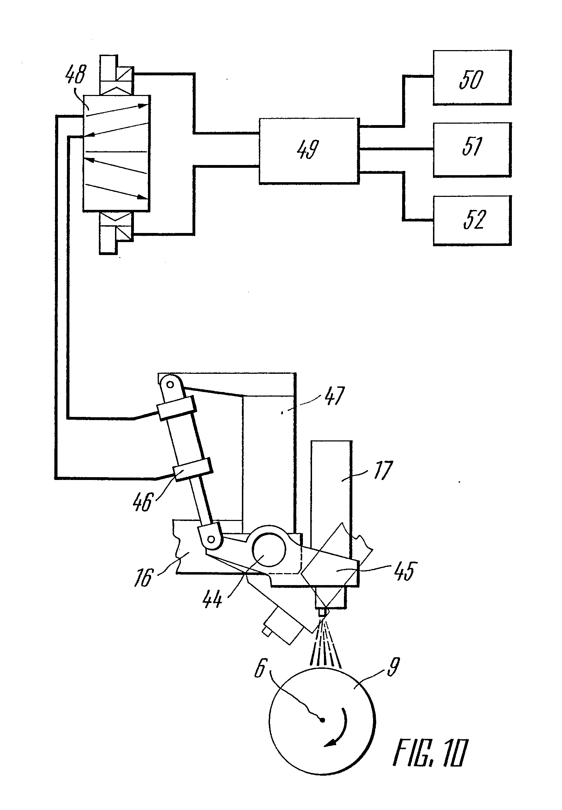

Der Antrieb 19 (Fig. 5) zur hin- und hergehenden
Querbewegung der Stange 16 ist in Form einer Kurve 24,
die an einer Antriebswelle 25 befestigt ist, und eines
zweiarmigen Hebels 26 (Fig. 5, 6) ausgebildet, dessen
Arm 27 mittels einer Rolle 28 mit der Kurve 24 verbunden
ist, während der Arm 29 mittels eines Gelenkes 30 mit
der Stange 16 verbunden ist. Im Schlitten 13 ist eine
Nut 31 ausgeführt und im Hebel 26 ist eine Längnut 32
vorgesehen. In den Nuten 31 und 32 befinden sich Gleitstücke 33, 34 der Einrichtungen zur Änderung der Hubgröße der Stange 16. Die Gleitstücke 33 und 34 sind so angeordnet, daß sie Einstellverschiebungen in den Nuten
31 und 32 ausführen und in ihren Stellungen fixiert werden können (die Feststeller sind in den Zeichnungen nicht wiedergegeben). In den Gleitstücken 33 und 34 ist ein Gelenkbol-

zen 35 angeordnet.

Es ist vorgesehen, daß im Antrieb 19 an der Antriebswelle 25 eine auswechselbare Kurve 36 (Fig. 7) und ein auswechselbarer zweiarmiger Hebel 37 angeordnet werden, der mit der Kurve 36 und mit der Stange 16 verbunden ist. Das Profil der Kurve 36 entspricht dem Profil der Oberfläche 38 des Werkstückes 39 vom Typ Rotationskörper mit einer vom Zylinder abweichenden Form.

Die Stange 16 ist in die Kammer 1 durch einen Schlitz 40 (Fig. 8) geführt, der in der hinteren Wand 11 der Kammer 1 in der Bewegungsrichtung des Schlittens 13 über die gesamte Hublänge desselben ausgeführt ist. Zur Wärmeisolierung und zur Schalldämmung der Kammer 1 von der Umwelt ist der Schlitz 40 mit einem bandförmigen Schieber 41 abgeschlossen, dessen Breite die Breite des Schlitzes 40 überschreitet. Der Schieber 41 ist in Führungen 42 (Fig. 8, 9) so angeordnet, daß er Längsbewegungen ausführen kann und mit einem Hohlstößel 43 in Wechselwirkung steht, der am Schlitten 13 befestigt ist. Die Stange 16 ist in dem Hohlstößel 43 unter Belassen eines Spaltes untergebracht. Am vorderen Ende der Stange 16 ist an einem Gelenk 44 (Fig. 10), dessen Achse parallel zu der Achse 6 der Spitzen verläuft, eine Schwenkkonsole 45 montiert. Der Zerstäuber 17 ist an der Schwenkkonsole 45 so angeordnet, daß er regelbare senkrechte Bewegungen ausführen kann, wobei die Konsole 45 mit einem Druckluftzylinder 46 verbunden ist, der an einer an der Stange 16 befestigten Konsole 47 angelenkt ist. Über einen pneumatischen Verteiler 48 und ein Relais 49 ist der Druckluftzylinder 46 mit einem Anlasser 50 des Antriebes 4 (Fig. 1) zur Drehbewegung des Spindelstockes 3, einem Anlasser 51 (Fig. 10) des Antriebes 14 (Fig. 2) zur Bewegung des Schlittens 13 und einem Anlasser 52 (Fig. 10) des Antriebes 19 (Fig. 2) zur Bewegung der Stange 16 verbunden.

Die Anlage wird in einem von zwei Betriebszuständen betrieben, der durch den Typ des Werkstückes, d.h. durch

0346468

Rotations- oder Flachkörper bestimmt wird.

Beim Auftragen eines Überzuges auf das Werkstück 9 (Fig. 1) vom Typ Rotationskörper wird die Anlage wie folgt betrieben. In Abhängigkeit vom Durchmesser des Werkstückes 9 wird der Zerstäuber 17 durch dessen Verschiebung (Fig. 10) über die Konsole 45 in eine senkrechte Stellung gebracht. Bei der Zuführung des Werkstückes 9 (Fig. 1) sind die Schiebetüren 12 auseinandergeschoben, die Stange 16 (Fig. 2) mit dem Zerstäuber 17 ist in Richtung zu der hinteren Wand 11 (Fig. 1) hin abgeführt, und der Zerstäuber 17 (Fig. 10) mit der Konsole 45 ist in eine geneigte Ruhestellung geschwenkt. Das Werkstück 9 (Fig. 1) wird im Futter 8 des Spindelstockkes 3 festgespannt und bei Bedarf von der Spitze 10 des Reitstockes 5 angedrückt. Es werden folgende technologische Betriebsbedingungen vorgegeben: Rotationsgeschwindigkeit des Futters 8, Bewegungsgeschwindigkeit des Schlittens 13 (Fig. 2), Hubgröße des Schlittens 13, welche sich nach der Länge des Werkstückes 9 (Fig. 1) richtet, sowie Anzahl der hin- und hergehenden Bewegungen des Schlittens 13. Die Schiebetüren 12 werden geschlossen. Man schaltet den Antrieb 4 zur Drehbewegung ein und beginnt mit der Zuführung der Überzugskomponenten in den Zerstäuber 17 (Fig. 2). Mittels der Stange 16 wird der Zerstäuber 17 von der hinteren Wand 11 abgeführt, wobei er in die Arbeitsstellung oberhalb des Werkstückes 9 (Fig. 1) gebracht wird. Gleichzeitig werden der Druckluftzylinder 46 (Fig. 10) und der Antrieb 14 (Fig. 2) eingeschaltet. Dadurch wird der Zerstäuber 17 in eine senkrechte Stellung gebracht, während der Schlitten 13 anfängt, den Zerstäuber 17 an dem Werkstück 9 (Fig. 1) entlang zu bewegen. Das Auftragen eines Überzuges auf das Werkstück 9 wird nach einem vorgegebenen Programm bei der Drehbewegung des Werkstückes 9 mit einer vorgegebenen Geschwindigkeit und bei hin- und hergehenden Bewegungen des Zerstäubers 17 (Fig. 2) an der oberen Mantellinie des Werkstückes 9 (Fig. 1) entlang durchgeführt.

Bei den Bewegungen des Schlittens 13 wird von dem an diesem befestigten Hohlstößel 43 (Fig. 8) der bandförmige Schieber 41 in den Führungen 42 bewegt. Bei unvorhergesehenen Stillsetzungen des Antriebes 4 (Fig. 1) zur Drehbewegung oder des Antriebes 14 (Fig. 2) zur Bewegung des Schlittens 13 wird entsprechend der Anlasser 50 (Fig. 10) oder der Anlasser 51 ausgelöst, welche über das Relais 49 einen Befehl (dem pneumatischen Verteiler 48) zur Schwenkung des Zerstäubers 17 (Fig. 2) mittels des Druckluftzylinders 46 in eine geneigte Ruhestellung automatisch geben, in der die Überzugskomponenten auf das Werkstück 9 (Fig. 1) nicht gelangen. Bei unvorhergesehenen Stillsetzungen der Antriebe 4 und 14 (Fig. 2), wenn die gegenseitigen Bewegungen des Zerstäubers 17 und des Werkstückes 9 (Fig. 1) eingestellt werden, wird also das Auftragen eines Überzuges auf die Oberfläche des Werkstückes 9 verhindert. Beim Betrieb des Zerstäubers 17 (Fig. 2) fällt ein Teil des pulverförmigen Materials herunter. Der Tisch 20 (Fig. 4) sorgt zuverlässig dafür, daß das pulverförmige Material auf die Flächen 22 der Führung 7 nicht gelangt.

Nach der Vollendung des Programms zum Auftragen eines Überzuges auf das Werkstück 9 (Fig. 1) werden die Antriebe 4 und 14 (Fig. 2) automatisch abgeschaltet, die Anlasser 50 und 51 (Fig.10) geben einen Befehl zur Schwenkung des Zerstäubers 17 in eine geneigte Stellung, die Stange 16 mit dem Zerstäuber 17 wird an die hintere Wand 11 (Fig. 1) der Kammer 1 abgeführt, die Zuführung der Überzugskomponenten wird eingestellt, die Schiebetüren 12 werden geöffnet. Der Reitstock 5 wird von der Stirnfläche des Werkstückes 9 abgeführt, das Futter 8 wird losgespannt, und das Werkstück 9 wird aus der Kammer 1 ausgetragen.

Dann wird der Zyklus wiederholt.

Beim Auftragen eines Überzuges auf das Werkstück 21 (Fig. 4) vom flachen Typ wird die Anlage wie folgt betrieben. Bei offenen Türen 12 (Fig. 1) wird der Reitstock 5 in die rechte Endstellung gebracht. Das Werkstück 21 (Fig. 4) wird auf den Tisch 20 gesetzt und erforderlichenfalls festgespannt. Bei der Zuführung des Werkstückes 21 ist die Stange 16 (Fig. 2) mit dem Zerstäuber 17 in Richtung zu der hinteren Wand 11 (Fig. 1) der Kammer 1 abgeführt, wobei sich der Schlitten 13 in einer der Endstellungen befindet. In Abhängigkeit von der Höhe des Werkstückes 21 (Fig. 4) wird der Zerstäuber 17 durch dessen Verschiebung (Fig. 2) über die Konsole 45 (Fig. 10) in eine senkrechte Stellung relativ zu der aufzustäubenden Fläche des Werkstückes 21 (Fig. 4) gebracht. In Abhängigkeit von der Breite des Werkstückes 21 wird die Hubgröße bei den Querbewegungen der Stange 16 (Fig. 2) mit dem Zerstäuber 17 eingestellt. Zu diesem Zweck werden die Gleitstücke 33 und 34 (Fig. 6) in den Nuten 31 und 32 (Fig. 5) verschoben, wobei dadurch das Verhältnis zwischen den Längen der Arme 27 und 29 und folglich die Hubgröße der Stange 16 geändert werden. Nach der Verschiebung der Gleitstücke 33 und 34 (Fig. 6) um die erforderliche Größe wird deren Stellung in den Nuten 31 (Fig. 5) und 32 fixiert.

Es werden folgende technologische Betriebsbedingungen vorgegeben: Bewegungsgeschwindigkeit des Schlittens 13 (Fig. 1), Hubgröße des Schlittens 13, welche durch die Länge des Werkstückes 21 (Fig. 4) bestimmt wird, Anzahl der hin- und hergehenden Bewegungen des Schlittens 13 (Fig. 1) und Bewegungsgeschwindigkeit der Stange 16 (Fig. 2). Die Schiebetüren 12 (Fig. 1) der Kammer 1 werden geschlossen. Man schaltet den Antrieb 14 (Fig. 2) zur Bewegung des Schlittens 13 und den Antrieb 19 zur Bewegung der Stange 16 ein. Gleichzeitig wird die Zuführung der Überzugskomponenten in den Zerstäuber 17 eingeschaltet. Das Auftragen des Überzuges auf das Werkstück 21 (Fig. 4) wird nach einem vorgegebenen Programm bei hin- und hergehenden Längs- und Querbewegungen des Zerstäubers 17 (Fig. 2) in Horizontalebene oberhalb der Oberfläche des Werkstückes 21 (Fig. 4) durchgeführt. Bei den Bewegungen der Stange 16 (Fig. 2) geht sie innerhalb des Hohlstößels 43 (Fig. 8) in Querrichtung frei durch und bewegt sich zusammen mit diesem in Längsrichtung.

Bei unvorhergesehenen Stillsetzungen des Antriebes 14 (Fig. 2) oder des Antriebes 19 werden der Anlasser 51 (Fig. 10) oder der Anlasser 52 entsprechend ausgelöst, welche über das Relais 49 einen Befehl dem pneumatischen Verteiler 48 zur Schwenkung des Zerstäubers 17 mittels des Druckluftzylinders 46 in eine geneigte Ruhestellung automatisch geben, in der die Überzugskomponenten auf das Werkstück 21 (Fig. 4) nicht mehr gelangen. Nach der Vollendung des Programms zum Auftragen eines Überzuges auf das Werkstück 21 werden die Antriebe 14 (Fig. 2) und 19 automatisch abgeschaltet. Dabei wird der Zerstäuber 17 in der Ausgangsstellung stillgesetzt, d.h. er ist an die hintere Wand 11 (Fig. 1) der Kammer 1 abgeführt. Die Zuführung der Überzugskomponenten wird eingestellt, die Türen 12 werden geöffnet, und das Werkstück 21 (Fig. 4) wird aus der Kammer 1 (Fig. 1) ausgetragen. Der Zyklus wird wiederholt.

Beim Auftragen eines Überzuges auf das Werkstück 39 (Fig. 7) vom Typ Rotationskörper mit einer vom Zylinder abweichenden Form wird die Anlage wie folgt betrieben.

An der Antriebswelle 25 wird die auswechselbare Kurve 36 befestigt, und am Gelenkbolzen 35 wird der zweiarmige Hebel 37 angeordnet, der mit der Kurve 36 und mit der Stange 16 verbunden wird. Das Werkstück 39 wird im Futter 8 festgespannt und erforderlichenfalls durch die rotierende Spitze 10 des Reitstockes 5 angedrückt.

Mittels einstellender Bewegungen des Schlittens 13 (Fig. 2) und der Stange 16 (Fig. 7) wird der Zerstäuber 17 auf eine vorgegebene Entfernung von den Flächen 38 des Werkstückes 39 herangeführt, welche Flächen 38 eine vom Zylinder abweichende Form aufweisen.

Es werden folgende technologische Betriebsbedingungen vorgegeben: Rotationsgeschwindigkeit des Futters 8, Bewegungsgeschwindigkeit des Schlittens 13 (Fig. 2), Hubgröße des Schlittens 13, welche durch die Länge der Fläche 38 (Fig. 7) bestimmt wird, Anzahl der hin- und hergehenden Bewegungen des Schlittens 13 (Fig. 2) sowie Rotationsgeschwindigkeit der Kurve 36 (Fig. 7), welche sich nach der Rotationsgeschwindigkeit des Futters 8 richtet. Bei den geschlossenen Türen 12 (Fig. 1) werden gleichzeitig der Antrieb 4 zur Drehbewegung und der Antrieb 19 (Fig. 2) zur Bewegung der Stange 16 eingeschaltet, wonach der Antrieb 14 zur Bewegung des Schlittens 13 und die Zuführung der Überzugskomponenten in den Zerstäuber 17 eingeschaltet werden.

Das Auftragen eines Überzuges auf die Fläche 38 (Fig. 7), die eine vom Zylinder abweichende Form aufweist, wird nach einem vorgegebenen Programm bei der Drehbewegung des Werkstückes 39, bei hin- und hergehenden Bewegungen des Schlittens 13 (Fig. 2) und bei der Querbewegung der Stange 16 durchgeführt. Da das Profil der Kurve 36 (Fig. 7) dem Profil der Fläche 38 entspricht, wird während der Drehbewegung des Werkstückes 39 der Abstand zwischen dem Zerstäuber 17 und der Fläche 38 konstant bleiben.

Nach der Vollendung des Programms zum Auftragen eines Überzuges auf das Werkstück 39 werden die Antriebe 4 (Fig. 1) und Antriebe 14, 19 (Fig. 2) automatisch abgeschaltet, die Zuführung der Überzugskomponenten wird eingestellt, und bei offenen Türen 12 (Fig. 1) wird das Werkstück 39 (Fig. 7) ausgetragen. Dann wird der Zyklus wiederholt.

Falls es notwendig ist, die Anlage zur Bearbeitung durch Schleifmittelstrahlen der Oberfläche eines Werkstückes zu verwenden, wird an der Stange 16 anstelle des Zerstäubers 17 (Fig. 2) ein entsprechendes Werkzeug angebracht. Alle übrigen technologischen Arbeitsgänge werden wie oben beschrieben ausgeführt.

Die erfindungsgemäße Anlage gestattet es, die techno-

logischen Möglichkeiten gegenüber den bekannten ähnlichen Anlagen zum Auftragen von gasthermischen Überzügen wesentlich zu erweitern. Dadurch, daß in der Anlage ein Tisch 20 (Fig. 4) vorgesehen ist und der Antrieb 19 (Fig. 2) zur Querbewegung der Stange 16 mit dem Zerstäuber 17 in Form eines Kurvenmechanismus ausgebildet ist, wird es möglich, Überzüge nicht nur auf Werkstücke vom Typ Rotationskörper, sondern auch auf Werkstücke von flachen Typ aufzutragen. Das Vorhandensein eines Kurvenmechanismus gestattet es außerdem, Überzüge auf Werkstükke vom Typ Rotationskörper, die eine vom Zylinder abweichende Form aufweisen, aufzutragen. Ein solcher Mechanismus ist einfacher und billiger, als die bekannten Mechanismen, bei denen das Bewegungsgesetz von einer kostspieligen Programmierungseinrichtung vorgegeben wird.

Dadurch, daß die Antriebe 14, 19 und die Führungen 15, 18 des Schlittens 13 und der Stange 16 außerhalb der Kammer 1 (Fig. 1) angeordnet sind, wird es möglich, den Einfluß hoher Temperatur und hohen Staubgehaltes auf deren Betriebsfähigkeit und Verschleißfestigkeit bei einer längeren, beim Beschichten großer Flächen von flachen Werkstücken erforderlichen Betriebzeit des Zerstäubers 17 (Fig. 2) auszuschließen.

Es wurde die Frage des Durchganges der Stange 16 in die Kammer 1 hinein günstig gelöst; diese Stange 16, welche den Zerstäuber 17 trägt, bewegt sich innerhalb des Schlitzes 40 (Fig. 8) in Längs- und Querrichtungen, ohne dabei die Wärmeisolierung und die Schalldämmung der Kammer 1 (Fig. 1) gegen die Umgebung zu beeinträchtigen. Es wurde die Verschleißfestigkeit der Führung 7 des Reitstockes 5 dadurch erhöht, daß an dieser der Tisch 20 (Fig. 4) befestigt wird, der die Laufflächen der Führung 7 gegen aufzustäubende pulverförmige Komponenten schützt. Die automatische Abführung des Zerstäubers 17 von der aufzustäubenden Fläche im Falle unvorhergesehener Stillsetzungen eines beliebigen der Antriebe 4 (Fig. 1), 14, 19 (Fig. 2) verhindert die Bildung lokaler Verdickungen der Überzugsschicht auf der aufzustäuoenden Fläche.

## Gewerbliche Anwendbarkeit

Die Erfindung kann zum Auftragen gasthermischer Überzüge aller Art auf Werkstücke vom Typ Rotationskörper sowie auf flache Werkstücke verwendet werden. Außerdem kann die Erfindung zur Vorbehandlung der Oberflächen von Werkstücken vor dem Auftragen von Überzügen, z.B., bei der Schleifmittelbearbeitung von Oberflächen verwendet werden.

PATENTANSPRÜCHE :

1. Anlage zum Auftragen von gasthermischen Überzügen auf Werkstücke, enthaltend eine kastenförmige Kammer (1), in der Kammer (1) koaxial angeordnet : einen Spindelstock (3), der mit einem Antrieb (4) zur Drehbewegung versehen ist, und einen Reitstock (5) mit einer Führung (7), der Längsbewegungen relativ zum Werkstück (9) in dieser Führung (7) ausführen kann, einen Schlitten (13) mit einem Antrieb (14) und einer Führung (15), der hin- und hergehende Längsbewegungen relativ zum Werkstück (9) in der Führung (15) ausführen kann, eine Stange (16) mit einem an dieser angebrachten Zerstäuber (17), die in am Schlitten (13) befestigten Führungen (18) Querbewegungen relativ zum Werkstück (9) ausführen kann, dadurch g e k e n n z e i c h n e t, daß sie einen Tisch (20), der an der Führung (7) des Reitstockes (5) befestigt ist, in dem eine Öffnung (23) mit die Querschnittsabmessungen des Tisches (20) überschreitenden Abmessungen vorgesehen ist, einen Antrieb (19) zur hin- und hergehenden Querbewegung der Stange (16) relativ zum Werkstück (9) sowie eine mit dem genannten Antrieb kinematisch verbundene Einrichtung zur Änderung der Kolbenhubgröße enthält, wobei die hintere Wand (11) der Kammer (1) einen Längsschlitz (40) hat, und die Kammer (1) mit einem Schieber (41) versehen ist, welcher so angeordnet ist, daß er Längsbewegungen relativ zum Werkstück (9) ausführen kann und mit einem Hohlstößel (43) in Wechselwirkung steht, der am Schlitten (13) befestigt ist und in dem die Stange (16) untergebracht ist, und außerdem der Antrieb (14) des Schlittens (13) und der Antrieb (19) zur hin- und hergehenden Querbewegung der Stange (16) sowie die Führungen (15, 18) des Schlittens (13) und der Stange (16) an der Außenseite der hinteren Wand (11) der Kammer (1) angeordnet sind.

2. Anlage zum Auftragen von gasthermischen Überzügen auf Werkstücke nach Anspruch 1, dadurch g e - k e n n z e i c h n e t , daß der Antrieb (9) zur hin- und hergehenden Querbewegung der Stange (16) in Form einer Kurve (24) und eines zweiarmigen Hebels (26) ausgebildet ist, bei dem der eine Arm (27) mit der Kurve (24) und der andere Arm (29) mit der Stange (16) verbunden sind.

3. Anlage zum Auftragen von gasthermischen Überzügen auf Werkstücke nach Ansprüchen 1 und 2, dadurch g e - k e n n z e i c h n e t , daß die Einrichtung zur Änderung der Stangenhubgröße zwei Gleitstücke (33, 34), welche in Nuten (31, 32) verschiebbar angeordnet sind, von denen die eine Nut (31) im Schlitten (13) und die andere Nut (32) im zweiarmigen Hebel (26) des Antriebes (19) zur hin- und hergehenden Querbewegung der Stange (16) ausgeführt sind, sowie einen in den Gleitstücken (33, 34) angeordneten Gelenkbolzen (35) enthält.

4. Anlage zum Auftragen von gasthermischen Überzügen auf Werkstücke nach Anspruch 1, dadurch g e k e n n - z e i c h n e t , daß die Länge und die Breite des Tisches (20) Abmessungen aufweisen, die die Abmessungen der Flächen (22) der Führung (7) des Reitstockes (5) übersteigen, welche mit dem Reitstock (5) in Wechselwirkung stehen.

5. Anlage zum Auftragen von gasthermischen Überzügen auf Werkstücke nach Anspruch 2, dadurch g e k e n n - z e i c h n e t , daß das Profil der Kurve (36) des Antriebes (19) zur hin- und hergehenden Querbewegung der Stange (16) dem Profil der Oberfläche des Werkstückes (39) entspricht, auf welche der Überzug aufgetragen wird.

0346468

FIG. 1

FIG. 3

**FIG. 2**

**FIG. 4**

FIG. 5

**FIG. 6**

**FIG. 7**

0346468

**FIG. 8**

**FIG. 9**

FIG. 10

# INTERNATIONAL SEARCH REPORT

International Application No  PCT/SU 87/00128

## I. CLASSIFICATION OF SUBJECT MATTER (if several classification symbols apply, indicate all) •

According to International Patent Classification (IPC) or to both National Classification and IPC

IPC⁴ — C 23 C 4/00, 14/34

## II. FIELDS SEARCHED

| Minimum Documentation Searched ⁷ | |
|---|---|
| Classification System | Classification Symbols |
| IPC⁴ | C 23 C 4/00, 14/34, B 05 B 17/20 |

Documentation Searched other than Minimum Documentation
to the Extent that such Documents are Included in the Fields Searched ⁸

## III. DOCUMENTS CONSIDERED TO BE RELEVANT⁹

| Category • | Citation of Document, ¹¹ with indication, where appropriate, of the relevant passages ¹² | Relevant to Claim No. ¹³ |
|---|---|---|
| A | FR, A1, 2557149, (ETAT FRANÇAIS Représenté par le Ministre des PTT CENTRE NATIONAL D'ETUDES DES TELECOMMUNICATIONS (C.N.E.T.), et al.), 28 June 1985 (28.06.85), see the drawing | 1-5 |
| A | CH, A5, 656400, (Gennady Vasilievich Kljuchko et al.), 30 June 1986 (30.06.86), see figures 1, 4-8 | 1-5 |
| A | GB, A, 2174717, (AE PLC.), 12 November 1986 (12.11.86), see the drawing | 1-5 |

* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

## IV. CERTIFICATION

| Date of the Actual Completion of the International Search | Date of Mailing of this International Search Report |
|---|---|
| 11 May 1988 (11.05.88) | 08 August 1988 (08.08.88) |
| International Searching Authority | Signature of Authorized Officer |
| ISA/SU | |

Form PCT/ISA/210 (second sheet) (January 1985)